# EUROPEAN PATENT SPECIFICATION

(11) **EP 3 056 822 B1**
(45) Date of publication and mention of the grant of the patent: **04.03.2020**
(21) Application number: 16150901.3
(22) Date of filing: 12.01.2016
(51) Int. Cl.: F24C 15/00

(54) **COOKING APPLIANCE**
KOCHVORRICHTUNG
APPAREIL DE CUISSON

(30) Priority: 16.01.2015 KR 20150007889
(43) Date of publication of application: 17.08.2016
(73) Proprietor: LG Electronics Inc., Seoul 07336 (KR)
(72) Inventor: NA, Yiksoo, 08592 Seoul (KR)
(74) Representative: Vossius & Partner Patentanwälte Rechtsanwälte mbB

(56) References cited:
- EP-A1- 0 833 108
- DE-A1-102007 005 718
- FR-A1- 2 726 633
- GB-A- 2 256 921
- US-A- 3 889 100

## Description

### BACKGROUND OF THE INVENTION

### Field of the Invention

The present invention relates to a cooking appliance, and more particularly to a cooking appliance that is capable of preventing the increase in temperature of a circuit board (i.e. a controller) configured to control the cooking appliance.

### Discussion of the Related Art

In general, cooking appliances are products for cooking food using electricity or other kinds of energy (e.g. gas) at home or the like.

Among cooking appliances, there are a gas stove, a gas oven, and a gas oven/stove, which use gas as a heat source. In addition, there are an induction stove, an electric stove having a radiant heater, and a microwave oven, which use electricity as a heat source. Furthermore, there is a combination type cooking appliance including an induction stove, which uses electricity, and a gas oven, which uses gas.

For example, a gas oven/stove may be configured such that a gas stove is provided as a first cooking unit, and a gas oven, as a second cooking unit, may be disposed under the gas stove.

For an electric oven/stove, an electric stove or an induction stove may be provided as a first cooking unit, and an electric oven, as a second cooking unit, may be disposed under the electric stove or the induction stove.

Meanwhile, a control panel, which allows a user to control at least one selected from between the first cooking unit and the second cooking unit, may be provided at the front of the cooking appliance.

In addition, a circuit board (i.e. a controller), configured to control the first cooking unit and the second cooking unit according to the user's manipulation of the control panel, may be disposed at the rear (or the rear surface) of the control panel.

Heat generated from at least one selected from between the first cooking unit and the second cooking unit may increase the temperature of the circuit board.

As the result of the increase in temperature of the circuit board, the circuit board may be damaged.

Furthermore, it may become impossible to control the first cooking unit and the second cooking unit due to such damage to the circuit board.

FR 2 726 633 A1 relates to a thermally insulated oven being closed at the front by a drop-down or side-hinged-door. Cooling air entering under the door passes through spaces within the door and out of the door top into a space between an oven top and a horizontal partition, where a fan expels the air at a rear of the oven. A subsidiary air flow above the horizontal partition cools electrical and electronic control circuits.

EP 0 833 108 A1 relates to an arrangement, with an oven having a cooling fan in a housing and a cooking hob in a housing on top, and having both housings combined through an air duct so that a fan can cool both.

GB 2 256 921 A relates to an oven wherein combustion products of a flame of a burner in a cavity of the oven are sucked through an opening into a duct by means of a fan and blown back into the room at a louvred opening beneath the oven cavity.

### SUMMARY OF THE INVENTION

Accordingly, the present invention is directed to a cooking appliance that substantially obviates one or more problems due to limitations and disadvantages of the related art.

An object of the present invention is to provide a cooking appliance that is capable of preventing the increase in temperature of a controller (i.e. a circuit board) due to heat generated from a cooking unit.

Another object of the present invention is to provide a cooking appliance configured such that a direction in which external air is introduced into the cooking appliance and a direction in which the external air is discharged from the cooking appliance are different from each other, whereby heat is efficiently dissipated from a controller.

Another object of the present invention is to provide a cooking appliance that is capable of preventing the increase in temperature of a controller, thereby preventing damage to the controller.

A further object of the present invention is to provide a cooking appliance that is capable of effectively preventing the increase in temperature of a controller by driving a fan.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a cooking appliance with the features of claim 1 is disclosed.

As the result of the heat dissipation fan being driven, external air may be introduced toward the rear of the cabinet through the at least one air introduction hole, and the external air may be discharged to the rear of the cabinet via the controller.

The control panel may be provided with a protruding part configured to protrude toward the front of the cabinet, and the at least one air introduction hole may be formed in the protruding part.

The at least one air introduction hole may be formed in the lower wall of the protruding part.

The lower wall of the protruding part may be parallel to a surface on which the cooking appliance is installed.

The at least one air introduction hole may include a plurality of air introduction holes provided in a width direction of the control panel.

The cooking appliance further includes a first guide member disposed in the control panel for guiding external air introduced through the at least one air introduction hole to the rear of the cooking appliance, wherein the controller may be disposed in front of the first guide member in the control panel.

The first guide member includes two horizontal parts extending in a width direction, two vertical parts extending downward from respective facing ends of the two horizontal parts, and a blocking part disposed between the two vertical parts for covering at least a portion of the rear end of each of the two vertical parts.

The two horizontal parts may be disposed at the lower side of the upper wall of the control panel such that the two horizontal parts are spaced apart from the upper wall of the control panel, whereby a first horizontal flow channel is defined between the two horizontal parts and the upper wall of the control panel, a first vertical flow channel may be defined between the two vertical parts, the controller being disposed in the first vertical flow channel, and the external air introduced through the at least one air introduction hole may be introduced into the first vertical flow channel via the first horizontal flow channel.

The first guide member may be provided with a first opening, the first opening being formed between the two vertical parts at the lower side of the blocking part, and the external air introduced into the first vertical flow channel may flow to the rear of the cooking appliance through the first opening.

The cooking appliance may further include a duct assembly disposed between the first cooking unit and the second cooking unit for guiding the external air introduced into the cooking appliance through the at least one air introduction hole to the rear of the cabinet.

The duct assembly may include an upper plate and a lower plate installed on the upper plate such that a second horizontal flow channel is defined between the upper plate and the lower plate.

The second horizontal flow channel may communicate with the first opening in the first guide member.

The cooking appliance may further include a second guide member installed on the upper plate at the rear of the first guide member, wherein the second guide member may be configured to guide external air having passed through the first opening in the first guide member to the second horizontal flow channel.

The second guide member may include a horizontal blocking part, a rear blocking part extending downward from the rear end of the horizontal blocking part, and side blocking parts extending downward from opposite sides of the horizontal blocking part in a width direction thereof.

The upper plate may be provided at the front end thereof with a first inclined part, the first inclined part being inclined downward, and each of the side blocking parts may be provided with a second inclined part corresponding to the first inclined part.

The first inclined part of the upper plate may be provided therein with at least one second opening such that air introduced between the second guide member and the first inclined part is introduced into the second horizontal flow channel through the at least one second opening.

The heat dissipation fan may be installed between the upper plate and the lower plate at the rear end of the duct assembly.

The cooking appliance may further include a rear panel installed at the rear end of the duct assembly such that the rear panel is perpendicular to a surface on which the cabinet is installed, wherein the rear panel may be provided at the upper end thereof with an air discharge port communicating with the outside.

The rear panel may have a second vertical flow channel defined therein, the second vertical flow channel extending in a vertical direction, and external air introduced through the at least one air introduction hole may sequentially pass through the first horizontal flow channel, the first vertical flow channel, the second horizontal flow channel, and the second vertical flow channel, and may then be discharged from the cooking appliance through the air discharge port.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a perspective view schematically showing a cooking appliance according to an embodiment of the present invention;
FIG. 2 is a sectional view showing a portion (the upper part) of the cooking appliance shown in FIG. 1;
FIG. 3 is a perspective view showing a control panel of the cooking appliance shown in FIG. 1;
FIG. 4 is a sectional view showing a first guide member and a second guide member disposed at the rear of the control panel of the cooking appliance shown in FIG. 1;
FIG. 5 is a perspective view of the first guide member shown in FIG. 4;
FIG. 6 is a perspective view of the second guide member shown in FIG. 4;
FIG. 7 is an exploded perspective view of the control panel, the first guide member, the second guide member, a duct assembly, and a fan; and
FIG. 8 is a view schematically showing the flow of external air that is introduced into the cooking appliance shown in FIG. 2 and is then discharged from the cooking appliance.

### DETAILED DESCRIPTION OF THE INVENTION

Reference will now be made in detail to the preferred embodiments of the present invention, examples of which are illustrated in the accompanying drawings. It should be noted herein that the construction of an apparatus, which will hereinafter be described, and a control method of the apparatus are given only for illustrative purposes and the protection scope of the invention is not limited thereto.

Wherever possible, the same reference numbers will be used throughout the drawings to refer to the same or like parts. In the drawings, sizes and shapes of elements may be exaggerated or reduced for convenience and clarity of description.

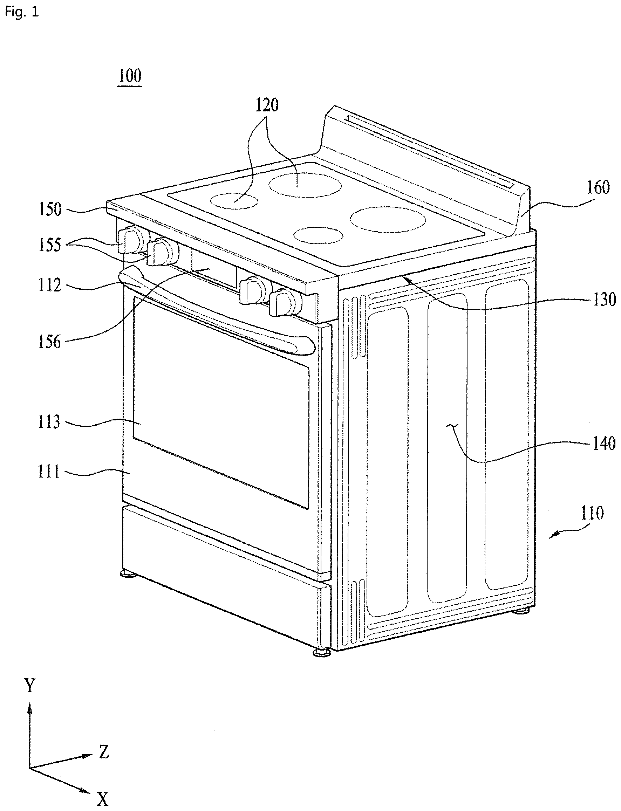

FIG. 1 is a perspective view schematically showing a cooking appliance according to an embodiment of the present invention.

Hereinafter, a cooking appliance that uses electricity as a heat source will be described by way of example for the sake of convenience. Alternatively, it is obvious that the characteristics of the present invention are also applicable to a cooking appliance that uses gas as a heat source.

Additionally, in FIG. 1, an X-axis direction will be defined as a width direction, a Y-axis direction will be defined as a height direction, and a Z-axis direction will be defined as a forward or rearward direction.

Referring to FIG. 1, a cooking appliance 100 according to the present invention includes a cabinet 110 defining the external appearance of the cooking appliance 100, a top plate 130 disposed at the top of the cabinet 110, the top plate 130 being provided with a first cooking unit 120, a second cooking unit 140 provided in the cabinet 120, a control panel 150 coupled to the front of the top plate 130, and a door 111 installed at the front of the cabinet 110 for opening and closing the second cooking unit 140.

In the cabinet 110 is defined a space for receiving the second cooking unit 140, in which cooking is performed using a heat source.

The top plate 130 is disposed at the top of the cabinet 110. In addition, the first cooking unit 120, on which cooking is performed using a heat source, is provided at the top plate 130.

Electricity or gas may be used for the heat sources of the first cooking unit 120 and the second cooking unit 140. For the sake of convenience, an example in which electricity is used for the heat sources of the first cooking unit 120 and the second cooking unit 140 will be described.

For example, the first cooking unit 120 may be provided with an induction heater or a radiant heater. In addition, the second cooking unit 140 may be provided with an electric heater.

A cooking unit using electricity is generally known as an induction stove, an electric stove, or an electric oven, and therefore a detailed description thereof will be omitted.

The control panel 150 is disposed at the front of the cabinet 110. Specifically, the control panel 150 may be disposed at the front of the top plate 130.

More specifically, the control panel 150 may be coupled to the top plate 130 at the upper side of the door 111, which is provided at the front of the cabinet 110 so as to open and close the second cooking unit 140.

The door 111 may be provided at the front of the cabinet 110 so as to open and close the second cooking unit 140. The door 111 may be provided with a transparent part, through which the interior of the second cooking unit 140 is visible, and a handle part 112 configured to open and close the door 111.

In addition, the control panel 150 may be provided with at least one manipulation part 155 and a control command input part 156.

Specifically, the manipulation part 155 may be formed to have a rotatable knob shape. In addition, the control command input part 156 may be configured as a touch panel.

In addition, the control command input part 156 may be configured to display information (e.g. a cooking course and cooking time) regarding cooking that is performed in the second cooking unit 140.

For example, a user may control the first cooking unit 120 through the manipulation part 155, and may control the second cooking unit 140 through the control command input part 156.

In addition, the cooking appliance 100 according to the embodiment of the present invention may further include a rear panel 160 installed at the rear of the upper side of the cabinet 110.

The rear panel 160 may be integrally formed with the top plate 130. Alternatively, the rear panel 160 may be manufactured separately from the top plate 130, and may be installed at the rear of the upper side of the cabinet 110.

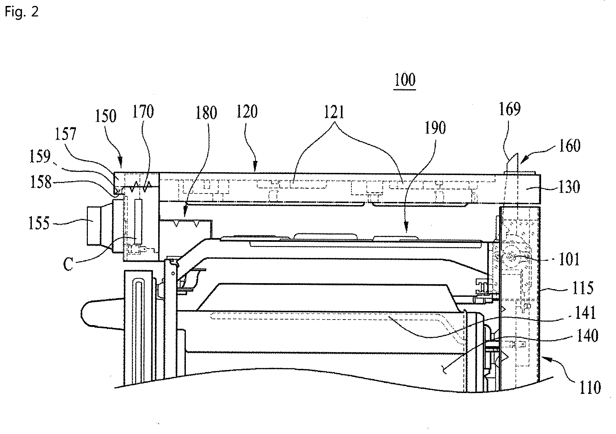

Meanwhile, a controller C (see FIG. 2), configured to control the first cooking unit 120 and the second cooking unit 140, may be provided in a space inside the control panel 150 or behind the control panel 150.

The controller C may be configured as a printed circuit board (PCB). The printed circuit board may be easily damaged due to heat.

That is, the controller C may be damaged due to heat generated from at least one selected from between the first cooking unit 120 and the second cooking unit 140.

In order to prevent the increase in temperature of the controller C, therefore, an air introduction hole and an air flow channel, which are configured to supply external air to the controller C, may be provided.

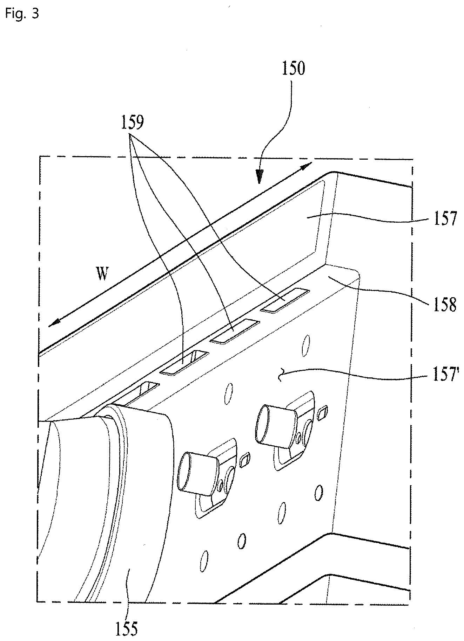

At least one air introduction hole (see FIG. 3) is formed in the control panel 150.

Consequently, external air may be introduced into the control panel 150 through the air introduction hole, which is formed in the control panel 150, may pass through the controller, and may be discharged from the cooking appliance 100 through an air discharge port formed in the rear panel 160.

Hereinafter, an air flow channel defined in the cooking appliance 100 will be described in detail with reference to FIG. 2.

FIG. 2 is a sectional view showing a portion (the upper part) of the cooking appliance shown in FIG. 1.

Referring to FIG. 2, the first cooking unit 120 may be provided with at least one first heater 121, and the second cooking unit 140 may be provided with at least one second heater 141. Heat generated from at least one selected from between the first cooking unit 120 and the second cooking unit 140 as the result of the operation thereof may increase the temperature of the controller C, which will be described hereinafter.

Hereinafter, a structure that is capable of preventing the increase in temperature of the controller C will be described.

First, at least one air introduction hole 159 is formed in the control panel 150.

In addition, the cooking appliance 100 according to the present invention further includes a controller C, disposed at the rear of the control panel 150 for controlling the first cooking unit 120 and the second cooking unit 140, and a heat dissipation fan 101, disposed between the control panel 150 and the rear wall 115 of the cabinet 110.

The controller C may be disposed closer to the front end of the cooking appliance 110 than to the rear end of the cooking appliance 110. That is, the controller C may be disposed closer to the front wall of the cabinet 110 than to the rear wall 115 of the cabinet 110. In other words, the controller C may be disposed closer to the door 111 than to the rear wall 115 of the cabinet 110.

In addition, the heat dissipation fan 101 may be disposed closer to the rear wall 115 of the cabinet 110 than to the control panel 150. The heat dissipation fan 101 may be disposed in the cabinet 110 such that the heat dissipation fan 101 is adjacent to the rear wall 115 of the cabinet 110.

Additionally, the heat dissipation fan 101 may be controlled by the controller C. For example, the controller C may control the heat dissipation fan 101 such that the heat dissipation fan 101 is driven when at least one selected from between the first cooking unit 120 and the second cooking unit 140 is operated.

The direction in which external air is introduced into the cooking appliance 100 (i.e. into the control panel 150) through the air introduction hole 159, which is formed in the control panel 150, and the direction in which the external air is discharged from the cooking appliance 100 are different from each other.

That is, the direction in which external air is introduced into the cooking appliance 100 through the air introduction hole 159 may be a rearward direction. Furthermore, the direction in which the external air is discharged from the cooking appliance 100 may be an upward direction.

For example, as the result of the operation of the heat dissipation fan 101, external air may be introduced toward the rear of the cabinet 110 through the air introduction hole 159, and the external air may be discharged to the rear of the cabinet 110 via the controller C.

More specifically, air, introduced into the cooking appliance 110 through the air introduction hole 159, maybe discharged upward from the cabinet 110 at the rear end of the cabinet 110.

The part (i.e. the front of the cooking appliance 100), through which external air is introduced into the cooking appliance 100, and the part (i.e. the rear of the cooking appliance 100), through which the external air is discharged from the cooking appliance 100, are sufficiently spaced apart from each other, thereby preventing interference between the air that is introduced and the air that is discharged.

Meanwhile, the control panel 150 may be provided with a protruding part 157 configured to protrude toward the front of the cabinet 110 (i.e. toward the front of the cooking appliance 100).

The air introduction hole 159 may be formed in the protruding part 157.

For example, the air introduction hole 159 may be formed in a lower wall 158 of the protruding part 157.

As a result, a structure that is capable of introducing external air into the control panel 150 (i.e. into the cooking appliance 100) without deteriorating the external appearance of the cooking appliance 100 may be provided.

In addition, the lower wall 158 of the protruding part 157 and the manipulation part 155 may be disposed so as to be spaced apart from each other by a predetermined distance such that external air can be easily introduced through the air introduction hole 159.

A plurality of air introduction holes 159 may be provided in a width direction of the control panel 150, which will be described in detail with reference to FIG. 3.

Meanwhile, the cooking appliance 100 according to the present invention further includes a first guide member 170 disposed in the control panel 150 for guiding external air introduced through the air introduction hole 159 to the rear of the cooking appliance 100.

The controller C is disposed in front of the first guide member 170 in the control panel 150.

As a result, external air introduced through the air introduction hole 159, formed in the control panel 150, may pass through the controller C while being guided to the rear of the cooking appliance 100 by the first guide member 170.

The first guide member 170 will be described in detail with reference to related drawings.

Meanwhile, the cooking appliance 100 according to the embodiment of the present invention may further include a duct assembly 190 disposed between the first cooking unit 120 and the second cooking unit 140. That is, the duct assembly 190 may be disposed between the first cooking unit 120 and the second cooking unit 140, which are disposed so as to be spaced apart from each other in upward and downward directions.

The duct assembly 190 may be configured to guide external air that has passed through the first guide member 170 to the rear of the cooking appliance 100.

That is, the duct assembly 190 may be configured to guide external air, introduced into the cooking appliance 100 through the air introduction hole 159, to the rear of the cooking appliance 100 (i.e. toward the rear of the cabinet 110).

The duct assembly 190 may include an upper plate 191 and a lower plate 192, which is coupled to the upper plate 191.

The duct assembly 190 will be described in detail with reference to related drawings.

In addition, the cooking appliance 100 according to the embodiment of the present invention may further include a second guide member 180 installed on the duct assembly 190 at the rear of the first guide member 170.

The second guide member 180 may be configured to guide the external air that has passed through the first guide member 170 to the inside of the duct assembly 190.

The second guide member 180 will be described in detail with reference to related drawings.

Meanwhile, the heat dissipation fan 101 may be installed at the rear end of the duct assembly 190 in the longitudinal direction thereof.

For example, the heat dissipation fan 101 may be installed between the upper plate 191 and the lower plate 192 at the rear end of the duct assembly 190 in the longitudinal direction thereof.

In addition, the rear panel 160 may be installed at the rear end of the duct assembly 190 in the longitudinal direction thereof such that the rear panel 160 is perpendicular to the surface on which the cabinet 110 is installed.

An air discharge port 169, which communicates with the outside, may be formed in the upper end of the rear panel 160.

As the result of the operation of the heat dissipation fan 101, therefore, external air may sequentially pass through the air introduction hole 159, the controller C, the first guide member 170, the second guide member 180, the duct assembly 190, and the rear panel 160, and may then be discharged from the cooking appliance 100.

That is, external air may be forcibly introduced into the cooking appliance 100 by the provision of the heat dissipation fan 101.

In the case in which external air is forcibly introduced into the cooking appliance 100 by the heat dissipation fan 101, heat may be dissipated from the controller C more effectively than in the case in which external air is introduced into the cooking appliance 100 by natural convection.

Hereinafter, the air introduction hole 159, which is formed in the control panel 150, will be described in detail with reference to FIG. 3.

FIG. 3 is a perspective view showing the control panel of the cooking appliance shown in FIG. 1.

Referring to FIG. 3 together with FIG. 2, the protruding part 157, which is configured to protrude toward the front of the cabinet 110, may be provided at the control panel 150.

That is, the control panel 150 may be provided at the front surface thereof with the protruding part 157 and a hollow part 157'.

The air introduction hole 159 may be formed in the protruding part 157, and the manipulation part 155 may be installed at the hollow part 157'.

More specifically, the air introduction hole 159 may be formed in the lower wall 158 of the protruding part 157.

As a result, a structure that is capable of introducing external air into the control panel 150 (i.e. into the cooking appliance 100) without deteriorating the external appearance of the cooking appliance 100 may be provided.

In addition, a plurality of air introduction holes 159 may be provided in a width direction W of the control panel 150.

More specifically, a plurality of air introduction holes 159 may be formed in the width direction of the control panel 150 such that the air introduction holes 159 are arranged at predetermined intervals.

As a result, the amount of external air that is introduced through the air introduction holes 159 is increased, and the strength of the control panel 150 is increased.

Meanwhile, the lower wall 158 of the protruding part 157 and the manipulation part 155 may be disposed so as to be spaced apart from each other by a predetermined distance.

More specifically, the lower wall 158 of the protruding part 157 and the upper end of the manipulation part 155 may be disposed so as to be spaced apart from each other.

As a result, the flow of external air introduced through the air introduction holes 159 may be prevented from being interfered with or obstructed by the manipulation part 155.

Hereinafter, the first guide member and the second guide member, which are disposed at the rear of the control panel 150, will be described in detail with reference to related drawings.

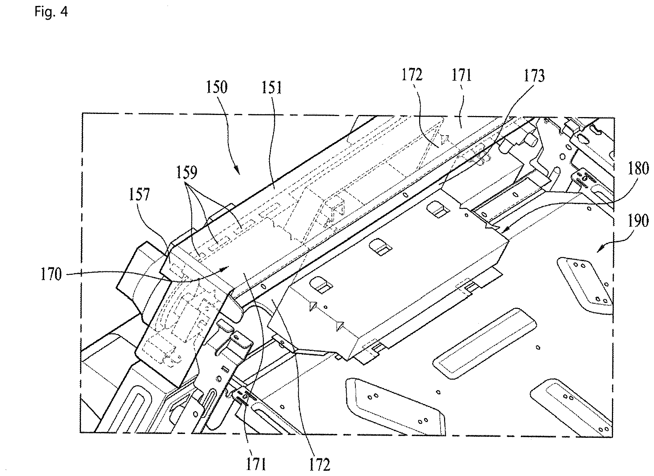

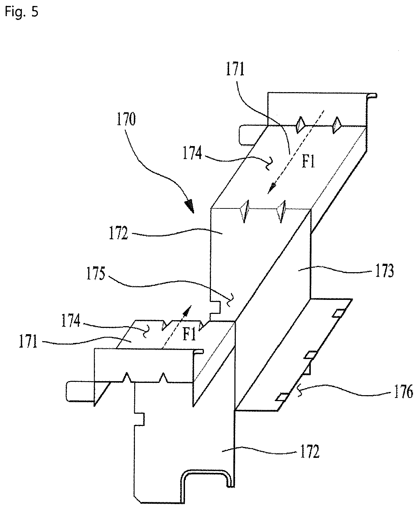

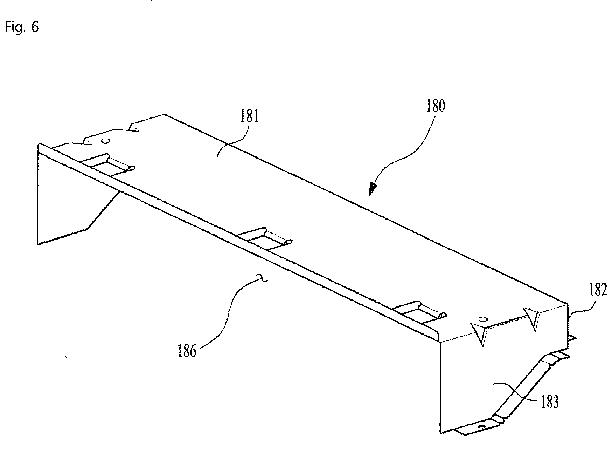

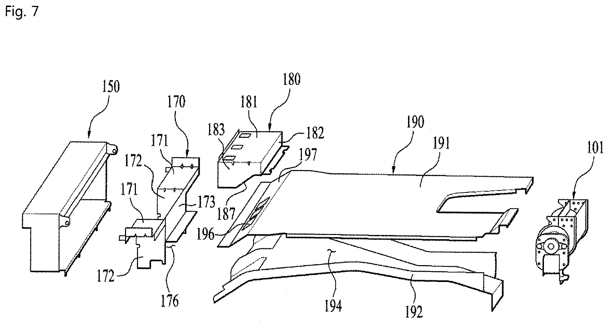

FIG. 4 is a sectional view showing the first guide member and the second guide member, which are disposed behind the control panel of the cooking appliance shown in FIG. 1, FIG. 5 is a perspective view of the first guide member shown in FIG. 4, FIG. 6 is a perspective view of the second guide member shown in FIG. 4, and FIG. 7 is an exploded perspective view of the control panel, the first guide member, the second guide member, the duct assembly, and the fan.

Referring first to FIG. 4, the cooking appliance 100 according to the embodiment of the present invention may further include a first guide member 170 disposed in the control panel 150 for guiding external air introduced through the air introduction hole 159 formed in the control panel 150.

For example, the first guide member 170 may be configured to guide external air, introduced through the air introduction hole 159, to the rear of the cooking appliance 100.

In addition, the first guide member 170 may be disposed at the rear end of the control panel 150, or may be disposed in the space inside the control panel 150.

In this embodiment, the first guide member 170 is disposed in the space inside the control panel 150.

In addition, the controller C may be disposed between the control panel 150 and the first guide member 170 (see FIG. 2).

More specifically, referring to FIG. 5 together with FIG. 4, the first guide member 170 may include two horizontal parts 171, which extend in the width direction, two vertical parts 172, which extend downward from respective facing ends of the two horizontal parts 171, and a blocking part 173 disposed between the two vertical parts 172 for covering at least a portion of the rear end of each of the two vertical parts 172.

The two horizontal parts 171 may be spaced apart from each other by a predetermined distance, and may extend in the horizontal direction.

In addition, the two horizontal parts 171 may be disposed at the lower side of an upper wall 151 of the control panel 150. For example, the two horizontal parts 171 may be disposed at the lower side of the upper wall 151 of the control panel 150 such that the two horizontal parts 171 are spaced apart from the upper wall 151 of the control panel 150.

As a result, a first horizontal flow channel 174 is defined between the two horizontal parts 171 and the upper wall 151 of the control panel 150.

External air introduced through the air introduction hole 159 formed in the control panel 150, may be guided to the middle part of the first guide member 170 in the width direction thereof through the first horizontal flow channel 174.

For example, the external air introduced through the air introduction hole 159 may be guided to the middle part of the first guide member 170 in the width direction thereof in a direction indicated by an arrow F1 shown in FIG. 5.

The two vertical parts 172 may extend downward from respective facing ends of the two horizontal parts 171.

The two vertical parts 172 may be spaced apart from each other by a predetermined distance. For example, the two vertical parts 172 may be spaced apart from each other by the distance between the facing ends of the two horizontal parts 171.

As a result, a first vertical flow channel 175 is defined between the two vertical parts 172. For example, the first vertical flow channel 175 may extend downward from the inner end of the first horizontal flow channel 174 in the width direction thereof.

Consequently, external air introduced through the air introduction hole 159 is introduced into the first vertical flow channel 175 via the first horizontal flow channel 174. That is, external air introduced through the air introduction hole 159 is sequentially guided to the first horizontal flow channel 174 and the first vertical flow channel 175.

Meanwhile, the controller C (see FIG. 2) is disposed in the first vertical flow channel 175. When external air flows through the first vertical flow channel 175, therefore, heat may be dissipated from the controller C as the result of heat exchange between the controller C and the external air.

In addition, the blocking part 173 may be disposed between the two vertical parts 172. The blocking part 173 may be configured to cover at least a portion of the rear end of each of the two vertical parts 172.

For example, the blocking part 173 may be disposed at the sides of the two vertical parts 172 that are far from the control panel 150. That is, the blocking part 173 may be disposed farther from the control panel 150 than the first vertical flow channel 175.

The blocking part 173 may be configured to cover a portion (e.g. the upper side) of the rear end of each of the two vertical parts 172. As a result, a first opening 176 may be formed between the two vertical parts 172 at the lower side of the blocking part 173.

That is, the first guide member 170 may be provided with a first opening 176 formed between the two vertical parts 172 at the lower side of the blocking part 173.

Consequently, external air introduced into the first vertical flow channel 175 may flow toward the rear of the cooking appliance 100 through the first opening 176.

That is, external air introduced through the air introduction hole 159 may sequentially pass through the first horizontal flow channel 174, the first vertical flow channel 175, and the first opening 176, and may then be guided to the rear of the cooking appliance 100 (i.e. the rear of the cabinet 110).

Meanwhile, the cooking appliance 100 according to the embodiment of the present invention may further include a duct assembly 190 configured to continuously guide external air, guided through the first opening 176, to the rear of the cooking appliance 100.

Specifically, referring to FIG. 7 together with FIG. 4, the duct assembly 190 may be configured to guide external air, introduced into the cooking appliance 100 through the air introduction hole 159, to the rear of the cooking appliance 100 (i.e. the rear of the cabinet 110).

The duct assembly 190 may be disposed at the rear of the first guide member 170.

More specifically, the duct assembly 190 may include an upper plate 191 and a lower plate 192, which is coupled to the upper plate 191.

In addition, a second horizontal flow channel 194 may be defined between the upper plate 191 and the lower plate 192.

That is, the upper plate 191 and the lower plate 192 may be coupled to each other such that the second horizontal flow channel 194 is defined between the upper plate 191 and the lower plate 192.

In addition, the second horizontal flow channel 194 may communicate with the first opening 176 formed in the first guide member 170.

Consequently, fluid that has passed through the first opening 176 may be guided to the rear of the cooking appliance 100 through the second horizontal flow channel 194.

That is, external air introduced through the air introduction hole 159 may be guided to the rear of the cooking appliance 100 through the first guide member 170, and may be continuously guided to the rear of the cooking appliance 100 through the duct assembly 190 (i.e. through the second horizontal flow channel 194).

In other words, the front end of the duct assembly 190 in the longitudinal direction thereof may be formed so as to communicate with the first opening 176, which is formed in the first guide member 170.

Meanwhile, the cooking appliance 100 according to the embodiment of the present invention may further include a second guide member 180 installed on the duct assembly 190 at the rear of the first guide member 170.

The second guide member 180 may be configured to guide external air that has passed through the first opening 176, which is formed in the first guide member 170, to the second horizontal flow channel 194.

Specifically, referring to FIG. 7 together with FIGs. 4 and 6, the second guide member 180 may be installed at the upper side of the duct assembly 190 at the rear end of the first guide member 170.

For example, the second guide member 180 may be installed on the upper plate 191 of the duct assembly 190. In other words, the second guide member 180 may be installed on the front end of the duct assembly 190 (i.e. on the front end of the upper plate 191).

The second guide member 180 may be configured to guide external air that has passed through the first opening 176 only to the second horizontal flow channel 194.

That is, the second guide member 180 may function to prevent external air that has passed through the first opening 176 from flowing to the parts of the cooking appliance 100 other than the second horizontal flow channel 194.

More specifically, the second guide member 180 may include a horizontal blocking part 181, a rear blocking part 182 extending downward from the rear end of the horizontal blocking part 181, and side blocking parts 183 extending downward from respective opposite sides of the horizontal blocking part 181 in the width direction thereof.

In addition, the front end of the second guide member 180 may be formed so as to be open. That is, the second guide member 180 may be provided at the front end thereof with an opening 186.

Consequently, air that has passed through the first guide member 170 may be introduced into the second guide member 180 through the opening 186 formed in the second guide member 180.

The horizontal blocking part 181 functions to prevent external air introduced into the second guide member 180 through the first guide member 170 from flowing to the upper side of the second guide member 180.

In addition, the rear blocking part 182 functions to prevent external air introduced into the second guide member 180 from flowing to the rear of the second guide member 180.

That is, the rear blocking part 182 may be configured to prevent external air introduced through the front of the second guide member 180 from flowing to the upper side of the duct assembly 190 without being introduced into the duct assembly 190.

In other words, the rear blocking part 182 may be configured to prevent external air from flowing to the rear of the cooking appliance 100 at the upper side of the duct assembly 190.

In addition, the side blocking parts 183 function to prevent external air introduced into the second guide member 180 from flowing to opposite sides of the second guide member 180 in the width direction thereof.

Meanwhile, the duct assembly 190 may be provided with a first inclined part 197, which is inclined downward. For example, the first inclined part 197 may be provided at the front end of the duct assembly 190.

Specifically, the first inclined part 197 may be provided at the upper plate 191 of the duct assembly 190. That is, the first inclined part 197, which is inclined downward, may be formed at the front end of the upper plate 191.

A second inclined part 187, which corresponds to the first inclined part 197, may be formed at each of the side blocking parts 183 of the second guide member 180.

In addition, at least one second opening 196 may be formed in the first inclined part 197 of the upper plate 191.

Consequently, external air introduced between the second guide member 180 and the first inclined part 197 through the first opening 176 may be introduced into the second horizontal flow channel 194, which is defined in the duct assembly 190, through the second opening 196.

Since the second opening 196 is formed in the first inclined part 197, external air may be smoothly guided to the horizontal flow channel 194 through the second opening 196.

The second opening 196 may be provided at the inside of each of the side blocking parts 183, which are provided at the second guide member 180, in the width direction thereof.

Consequently, external air introduced into the second guide member 180 may be guided into the second horizontal flow channel 194 through the second opening 196 without flowing to the outside of the second guide member 180 in the width direction thereof.

In addition, the cooking appliance 100 according to the embodiment of the present invention may further include a heat dissipation fan 101 disposed at the rear end of the duct assembly 190.

Specifically, referring to FIG. 7 together with FIG. 2, the heat dissipation fan 101 may be installed between the upper plate 191 and the lower plate 192 of the duct assembly 190 at the rear end of the duct assembly 190.

The heat dissipation fan 101 may be configured to suction external air through the second horizontal flow channel 194, which is defined in the duct assembly 190.

For example, the heat dissipation fan 101 may be configured to suction external air flowing in the second horizontal flow channel 194 and to supply the suctioned air into the rear panel 160 shown in FIG. 2.

That is, the rear end of the duct assembly 190 in the longitudinal direction thereof may communicate with the interior of the rear panel 160.

As the result of the operation of the heat dissipation fan 101, external air may be introduced through the air introduction hole 159 formed in the control panel 150. The external air may sequentially pass through the first guide member 170, the second guide member 180, and the duct assembly 190, and may then be discharged from the cooking appliance 100 through the air discharge port 169, which is formed in the rear panel 160.

That is, the rear end of the duct assembly 190 in the longitudinal direction thereof and the air discharge port 169, which is formed in the rear panel 160 may communicate with each other via the heat dissipation fan 101.

In addition, the rear panel 160 may be installed at the rear end of the duct assembly 190 such that the rear panel 160 is perpendicular to the surface on which the cabinet 110 is installed (i.e. the surface on which the cooking appliance 100 is installed).

The heat dissipation fan 101 may be disposed between the rear end of the duct assembly 190 and the lower end of the rear panel 160.

The heat dissipation fan 101 may be configured to draw external air flowing in the duct assembly 190 and to supply the drawn air toward the air discharge port 169, which is formed in the upper end of the rear panel 160.

As the result of the operation of the heat dissipation fan 101, external air may be forcibly suctioned from the front of the cooking appliance 100. In addition, the external air may be discharged from the cooking appliance 100 via the rear panel 160, which is provided at the rear of the cooking appliance 100.

That is, a part through which external air is introduced into the cooking appliance 100 may be located at the front end of the cooking appliance 100, and a part through which the external air is discharged from the cooking appliance 100 may be located at the rear end of the cooking appliance 100.

As a result, interference between air that is introduced into the cooking appliance 100 and air that is discharged from the cooking appliance 100 may be prevented, whereby heat may be efficiently dissipated from the controller C, which is provided between the first guide member 170 and the control panel 150.

Hereinafter, the flow of external air that is introduced into the cooking appliance 100 and is then discharged from the cooking appliance 100 will be described in detail with reference to related drawings.

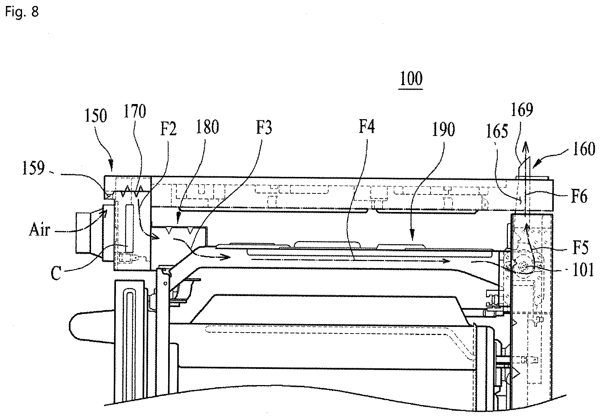

FIG. 8 is a view schematically showing the flow of external air that is introduced into the cooking appliance shown in FIG. 2 and is then discharged from the cooking appliance.

First, external air may be introduced into the cooking appliance 100 as the result of the operation of the heat dissipation fan 101. That is, external air may be introduced into the control panel 150.

That is, as shown in FIGs. 2 and 3, external air may be introduced into the control panel 150 through the air introduction hole 159, which is formed in the control panel 150.

The external air, introduced into the control panel 150, may be guided through the first horizontal flow channel 174, which is defined between the horizontal parts 171 of the first guide member 170 and the upper wall 151 of the control panel 150 in the direction indicated by the arrow F1 shown in FIG. 5.

The external air may be guided downward through the first vertical flow channel 175, which communicates with the first horizontal flow channel 174.

Specifically, the external air, guided along the first horizontal flow channel 174, may be guided along the first vertical flow channel 175 in a direction indicated by an arrow F2 shown in FIG. 8.

Heat may be dissipated from the controller C, which is disposed in the first vertical flow channel 175, as the result of heat exchange between the external air and the controller C.

The external air may be guided into the duct assembly 190 through the interior of the second guide member 180. That is, the external air may be guided in a direction indicated by an arrow F3 shown in FIG. 8.

The second guide member 180 may be configured to prevent the external air from flowing to the spaces in the cooking appliance 100 other than the interior of the duct assembly 190 when the external air is guided in the direction indicated by the arrow F3 shown in FIG. 8.

In addition, the external air may be guided to the rear of the cooking appliance 100 through the second horizontal flow channel 194, which is defined in the duct assembly 190, in a direction indicated by an arrow F4.

Subsequently, the external air may be guided into the rear panel 160 through the heat dissipation fan 101, which is disposed at the rear end of the duct assembly 190. That is, the flow of external air may be switched from the direction indicated by the arrow F4 to a direction indicated by an arrow F5 by the heat dissipation fan 101.

That is, the heat dissipation fan 101 may be configured to switch the direction in which the external air flows in the duct assembly 190 from the horizontal direction indicated by the arrow F4 to the vertical direction indicated by the arrow F5 such that the external air flows into the rear panel 160.

A second vertical flow channel 165, which extends in a vertical direction, may be defined in the rear panel 160.

Consequently, the external air may be guided upward through the second vertical flow channel 165 in a direction indicated by an arrow F6, and may then be discharged from the cooking appliance 100 through the air discharge port 169 formed in the upper end of the rear panel 160.

As described above, external air introduced through the air introduction hole 159, which is formed in the control panel 150, may sequentially pass through the first horizontal flow channel 174, the first vertical flow channel 175, the second horizontal flow channel 194, and the second vertical flow channel 165, and may then be discharged from the cooking appliance 100 through the air discharge port 169.

That is, external air introduced through the air introduction hole 159 may be guided to the middle part of the first horizontal flow channel 174 in the width direction thereof as indicated by the arrow F1 shown in FIG. 4, may be guided downward along the first vertical flow channel 175 as indicated by the arrow F2 shown in FIG. 8, may be guided to the rear of the cooking appliance 100 as indicated by the arrow F4, and may be discharged from the cooking appliance 100 as indicated by the arrow F6.

As is apparent from the above description, the present invention has the effect of providing a cooking appliance that is capable of preventing the increase in temperature of a controller (i.e. a circuit board) due to heat generated from a cooking unit.

In addition, the present invention has the effect of providing a cooking appliance configured such that a direction in which external air is introduced into the cooking appliance and a direction in which the external air is discharged from the cooking appliance are different from each other, whereby heat is efficiently dissipated from a controller.

In addition, the present invention has the effect of providing a cooking appliance that is capable of preventing the increase in temperature of a controller, thereby preventing damage to the controller.

In addition, the present invention has the effect of providing a cooking appliance that is capable of effectively preventing the increase in temperature of a controller through the operation of a fan.

## Claims

1. A cooking appliance (100) comprising a cabinet (110) defining an external appearance of the cooking appliance, a top plate (130) disposed at a top of the cabinet (110), the top plate (130) being provided with a first cooking unit (120) for performing cooking using a heat source, and a second cooking unit (140) provided in the cabinet (110) for performing cooking using a heat source, the cooking appliance (100) further comprising:
a control panel (150) disposed at a front of the cabinet (110), the control panel (150) being provided therein with at least one air introduction hole (159);
a controller (C) disposed at a rear of the control panel (150) for controlling the first cooking unit (120) and the second cooking unit (140);
a first guide member (170) disposed in the control panel (150) for guiding external air introduced through the at least one air introduction hole (159) to a rear of the cooking appliance (100), wherein the controller (C) is disposed in front of the first guide member (170) in the control panel (150); and
a heat dissipation fan (101) disposed between the control panel (150) and a rear wall of the cabinet (110), wherein
a direction in which external air is introduced into the cooking appliance (100) through the at least one air introduction hole (159) is different from a direction in which the external air is discharged from the cooking appliance (100), **characterized in that**
the first guide member (170) comprises: two horizontal parts (171) extending in a width direction; two vertical parts (172) extending downward from respective facing ends of the two horizontal parts (171); and a blocking part (173) disposed between the two vertical parts (172) for covering at least a portion of a rear end of each of the two vertical parts (172);
the controller (C) is disposed between the two vertical parts (172);
a first horizontal flow channel (174) is defined between the two horizontal parts (171) and an upper wall (151) of the control panel (150);
a first vertical flow channel (175) is defined between the two vertical parts (172), the controller (C) being disposed in the first vertical flow channel (175); and
the external air introduced through the at least one air introduction hole (159) is introduced into the first vertical flow channel (175) via the first horizontal flow channel (174).

2. The cooking appliance (100) according to claim 1, wherein as a result of the heat dissipation fan (101) being driven, external air is introduced toward a rear of the cabinet (110) through the at least one air introduction hole (159), and the external air is discharged to the rear of the cabinet (110) via the controller (C).

3. The cooking appliance (100) according to claim 1 or 2, wherein
the control panel (150) is provided with a protruding part (157) configured to protrude toward the front of the cabinet (110), and
the at least one air introduction hole (159) is formed in the protruding part (157).

4. The cooking appliance (100) according to claim 3, wherein the at least one air introduction hole (159) is formed in a lower wall of the protruding part (157).

5. The cooking appliance (100) according to claim 4, wherein the at least one air introduction hole (159) comprises a plurality of air introduction holes provided in a width direction of the control panel (150).

6. The cooking appliance (100) according to any of claims 1 to 5, wherein
the two horizontal parts (171) are disposed at a lower side of the upper wall (151) of the control panel (150) such that the two horizontal parts (171) are spaced apart from the upper wall (151) of the control panel (150).

7. The cooking appliance (100) according to claim 6, wherein
the first guide member (170) is provided with a first opening (176), the first opening (176) being formed between the two vertical parts (172) at a lower side of the blocking part (173), and
the external air introduced into the first vertical flow channel (175) flows to the rear of the cooking appliance (100) through the first opening (176).

8. The cooking appliance (100) according to any one of claims 1 to 7, further comprising a duct assembly (190) disposed between the first cooking unit (120) and the second cooking unit (140) for guiding the external air introduced into the cooking appliance (100) through the at least one air introduction hole (159) to a rear of the cabinet (110).

9. The cooking appliance (100) according to claim 8, wherein the duct assembly (190) comprises an upper plate (191) and a lower plate (192) installed on the upper plate (191) such that a second horizontal flow channel (194) is defined between the upper plate (191) and the lower plate (192).

10. The cooking appliance (100) according to claim 9, wherein
the second horizontal flow channel (194) communicates with the first opening (176) in the first guide member (170).

11. The cooking appliance (100) according to claim 9 or 10, further comprising:
a second guide member (180) installed on the upper plate (191) at a rear of the first guide member (170), wherein
the second guide member (180) is configured to guide external air having passed through the first opening (176) in the first guide member (170) to the second horizontal flow channel (194).

12. The cooking appliance (100) according to any one of claims 9 to 11, wherein
the upper plate (191) is provided at a front end thereof with a first inclined part (197), the first inclined part (197) being inclined downward, and
each of side blocking parts (183) is provided with a second inclined part (187) corresponding to the first inclined part (197).

13. The cooking appliance (100) according to claim 12, wherein the first inclined part (197) of the upper plate (191) is provided therein with at least one second opening (196) such that air introduced between the second guide member (180) and the first inclined part (197) is introduced into the second horizontal flow channel (194) through the at least one second opening (196).

## Patentansprüche

1. Kochvorrichtung (100) mit einem Gehäuse (110), das ein äußeres Erscheinungsbild der Kochvorrichtung definiert, einer oberen Platte (130), die auf dem Gehäuse (110) angeordnet ist, wobei die obere Platte (130) mit einer ersten Kocheinheit (120) zum Durchführen des Kochens mittels einer Wärmequelle und einer zweiten Kocheinheit (140) versehen ist, die im Gehäuse (110) zum Durchführen des Kochens mittels einer Wärmequelle vorgesehen ist, wobei die Kochvorrichtung (100) ferner aufweist:
ein Bedienungsfeld (150), das an einer Vorderseite des Gehäuses (110) angeordnet ist, wobei das Bedienungsfeld (150) mit mindestens einem Lufteinleitungsloch (159) darin versehen ist;
eine Steuereinrichtung (C), die auf einer Rückseite des Bedienungsfelds (150) zum Steuern der ersten Kocheinheit (120) und der zweiten Kocheinheit (140) angeordnet ist;
ein erstes Führungselement (170), das im Bedienungsfeld (150) zum Führen von Außenluft, die durch das mindestens eine Lufteinleitungsloch (159) eingeführt wird, zu einer Rückseite der Kochvorrichtung (100) angeordnet ist, wobei die Steuereinrichtung (C) vor dem ersten Führungselement (170) im Bedienungsfeld (150) angeordnet ist; und
ein Wärmeableitungsventilator (101), der zwischen dem Bedienungsfeld (150) und einer Rückwand des Gehäuses (110) angeordnet ist, wobei
sich eine Richtung, in der Außenluft durch das mindestens eine Lufteinleitungsloch (159) in die Kochvorrichtung (100) eingeführt wird, von einer Richtung unterscheidet, in der die Außenluft aus der Kochvorrichtung (100) ausgestoßen wird, **dadurch gekennzeichnet, dass** das erste Führungselement (170) aufweist: zwei horizontale Teile (171), die sich in eine Breitenrichtung erstrecken; zwei vertikale Teile (172), die sich von jeweiligen gegenüberliegenden Enden der beiden horizontalen Teile (171) nach unten erstrecken; und einen Sperrteil (173), der zwischen den beiden vertikalen Teilen (172) zum Abdecken von mindestens einem Abschnitt eines hinteren Endes der beiden vertikalen Teile (172) angeordnet ist;
die Steuereinrichtung (C) zwischen den beiden vertikalen Teilen (172) angeordnet ist;
ein erster horizontaler Strömungskanal (174) zwischen den beiden horizontalen Teilen (171) und einer oberen Wand (151) des Bedienungsfelds (150) definiert ist;
ein erster vertikaler Strömungskanal (175) zwischen den beiden vertikalen Teilen (172) definiert ist, wobei die Steuereinrichtung (C) im ersten vertikalen Strömungskanal (175) angeordnet ist; und
die durch das mindestens eine Lufteinleitungsloch (159) eingeführte Außenluft in den ersten vertikalen Strömungskanal (175) über den ersten horizontalen Strömungskanal (174) eingeführt wird.

2. Kochvorrichtung (100) nach Anspruch 1, wobei infolge dessen, dass der Wärmeableitungsventilator (101) betrieben wird, durch das mindestens eine Lufteinleitungsloch (159) Außenluft zu einer Rückseite des Gehäuses (110) eingeführt wird, und die Außenluft zur Rückseite des Gehäuses (110) über die Steuereinrichtung (C) ausgestoßen wird.

3. Kochvorrichtung (100) nach Anspruch 1 oder 2, wobei
das Bedienungsfeld (150) mit einem vorstehenden Teil (157) versehen ist, der konfiguriert ist, zur Vorderseite des Gehäuses (110) vorzustehen, und
das mindestens eine Lufteinleitungsloch (159) im vorstehenden Teil (157) ausgebildet ist.

4. Kochvorrichtung (100) nach Anspruch 3, wobei das mindestens eine Lufteinleitungsloch (159) in einer unteren Wand des vorstehenden Teils (157) ausgebildet ist.

5. Kochvorrichtung (100) nach Anspruch 4, wobei das mindestens eine Lufteinleitungsloch (159) mehrere Lufteinleitungslöcher aufweist, die in einer Breitenrichtung des Bedienungsfelds (150) vorgesehen sind.

6. Kochvorrichtung (100) nach einem der Ansprüche 1 bis 5, wobei die beiden horizontalen Teile (171) auf einer Unterseite der oberen Wand (151) des Bedienungsfelds (150) so angeordnet sind, dass die beiden horizontalen Teile (171) von der oberen Wand (151) des Bedienungsfelds (150) beabstandet sind.

7. Kochvorrichtung (100) nach Anspruch 6, wobei
das erste Führungselement (170) mit einer ersten Öffnung (176) versehen ist, wobei die erste Öffnung (176) zwischen den beiden vertikalen Teilen (172) auf einer Unterseite des Sperrteils (173) ausgebildet ist, und
die in den ersten vertikalen Strömungskanal (175) eingeführte Außenluft zur Rückseite der Kochvorrichtung (100) durch die erste Öffnung (176) strömt.

8. Kochvorrichtung (100) nach einem der Ansprüche 1 bis 7, die ferner eine Kanalanordnung (190) aufweist, die zwischen der ersten Kocheinheit (120) und der zweiten Kocheinheit (140) zum Führen der Außenluft angeordnet ist, die durch das mindestens eine Lufteinleitungsloch (159) in die Kochvorrichtung (100) eingeführt wird, zu einer Rückseite des Gehäuses (110).

9. Kochvorrichtung (100) nach Anspruch 8, wobei die Kanalanordnung (190) eine obere Platte (191) und eine untere Platte (192) aufweist, die an der oberen Platte (191) so angebracht ist, dass ein zweiter horizontaler Strömungskanal (194) zwischen der oberen Platte (191) und der unteren Platte (192) definiert ist.

10. Kochvorrichtung (100) nach Anspruch 9, wobei
der zweite horizontale Strömungskanal (194) mit der ersten Öffnung (176) im ersten Führungselement (170) in Verbindung steht.

11. Kochvorrichtung (100) nach Anspruch 9 oder 10, die ferner aufweist:
ein zweites Führungselement (180), das an der oberen Platte (191) auf einer Rückseite des ersten Führungselements (170) angebracht ist, wobei
das zweite Führungselement (180) konfiguriert ist, Außenluft, die durch die erste Öffnung (176) in das erste Führungselement (170) geströmt ist, zum zweiten horizontalen Strömungskanal (194) zu führen.

12. Kochvorrichtung (100) nach einem der Ansprüche 9 bis 11, wobei
die obere Platte (191) an deren vorderen Ende mit einem ersten geneigten Teil (197) versehen ist, wobei der erste geneigte Teil (197) nach unten geneigt ist, und
jeder der seitlichen Sperrteile (183) mit einem zweiten geneigten Teil (187) versehen ist, der dem ersten geneigten Teil (197) entspricht.

13. Kochvorrichtung (100) nach Anspruch 12, wobei der erste geneigte Teil (197) der oberen Platte (191) darin mit mindestens einer zweiten Öffnung (196) versehen ist, so dass zwischen dem zweiten Führungselement (180) und dem ersten geneigten Teil (197) eingeführte Luft durch die mindestens eine zweite Öffnung (196) in den zweiten horizontalen Strömungskanal (194) eingeführt wird.

## Revendications

1. Appareil de cuisson (100) comprenant une carrosserie (110) définissant un aspect extérieur dudit appareil de cuisson, une plaque supérieure (130) disposée sur le haut de la carrosserie (110), ladite plaque supérieure (130) étant pourvue d'une première unité de cuisson (120) pour effectuer une cuisson au moyen d'une source de chaleur, et d'une deuxième unité de cuisson (140) prévue dans la carrosserie (110) pour effectuer une cuisson au moyen d'une source de chaleur, ledit appareil de cuisson (100) comprenant en outre :
un panneau de commande (150) disposé sur le devant de la carrosserie (110), ledit panneau de commande (150) étant pourvu d'au moins un trou d'introduction d'air (159) ;
un dispositif de commande (C) disposé à l'arrière du panneau de commande (150) pour commander la première unité de cuisson (120) et la deuxième unité de cuisson (140) ;
un premier élément de guidage (170) disposé dans le panneau de commande (150) pour guider l'air extérieur entrant par ledit au moins un trou d'introduction d'air (159) vers l'arrière de l'appareil de cuisson (100), le dispositif de commande (C) étant disposé devant le premier élément de guidage (170) dans le panneau de commande (150) ; et
un ventilateur de dissipation de chaleur (101) disposé entre le panneau de commande (150) et une paroi arrière de la carrosserie (110), où
la direction de pénétration de l'air extérieur dans l'appareil de cuisson (100) par ledit au moins un trou d'introduction d'air (159) diffère de la direction d'évacuation de l'air extérieur hors de l'appareil de cuisson (100), **caractérisé en ce que**
le premier élément de guidage (170) comprend : deux sections horizontales (171) s'étendant dans le sens de la largeur ; deux sections verticales (172) s'étendant vers le bas depuis des extrémités respectives opposées des deux sections horizontales (171) ; et
une section de blocage (173) disposée entre les deux sections verticales (172) pour recouvrir au moins une partie d'une extrémité arrière de chacune des deux sections verticales (172) ;
le dispositif de commande (C) est disposé entre les deux sections verticales (172) ;
un premier canal d'écoulement horizontal (174) est défini entre les deux sections horizontales (171) et une paroi supérieure (151) du panneau de commande (150) ;
un premier canal d'écoulement vertical (175) est défini entre les deux sections verticales (172), le dispositif de commande (C) étant disposé dans le premier canal d'écoulement vertical (175) ; et
l'air extérieur pénétrant par ledit au moins un trou d'introduction d'air (159) est introduit dans le premier canal d'écoulement vertical (175) via le premier canal d'écoulement horizontal (174).

2. Appareil de cuisson (100) selon la revendication 1, où il résulte de l'entraînement du ventilateur de dissipation de chaleur (101) que l'air extérieur est introduit vers l'arrière de la carrosserie (110) par ledit au moins un trou d'introduction d'air (159), et que l'air extérieur est évacué à l'arrière de la carrosserie (110) via le dispositif de commande (C).

3. Appareil de cuisson (100) selon la revendication 1 ou la revendication 2, où
le panneau de commande (150) est pourvu d'une section en saillie (157) prévue pour s'étendre vers le devant de la carrosserie (110), et où
ledit au moins un trou d'introduction d'air (159) est formé dans la section en saillie (157).

4. Appareil de cuisson (100) selon la revendication 3, où ledit au moins un trou d'introduction d'air (159) est formé dans une paroi inférieure de la section en saillie (157).

5. Appareil de cuisson (100) selon la revendication 4, où ledit au moins un trou d'introduction d'air (159) comprend une pluralité de trous d'introduction d'air prévus dans le sens de la largeur du panneau de commande (150).

6. Appareil de cuisson (100) selon l'une des revendications 1 à 5, où les deux sections horizontales (171) sont disposées sur le bas de la paroi supérieure (151) du panneau de commande (150) de manière à espacer lesdites deux sections horizontales (171) de la paroi supérieure (151) du panneau de commande (150).

7. Appareil de cuisson (100) selon la revendication 6, où
le premier élément de guidage (170) est pourvu d'une première ouverture (176), ladite première ouverture (176) étant formée entre les deux sections verticales (172) sur le bas de la section de blocage (173), et
l'air extérieur introduit dans le premier canal d'écoulement vertical (175) s'écoule vers l'arrière de l'appareil de cuisson (100) par la première ouverture (176).

8. Appareil de cuisson (100) selon l'une des revendications 1 à 7, comprenant en outre un ensemble de conduite (190) disposé entre la première unité de cuisson (120) et la deuxième unité de cuisson (140) pour guider vers l'arrière de la carrosserie (110) l'air extérieur pénétrant dans l'appareil de cuisson (100) par ledit au moins un trou d'introduction d'air (159).

9. Appareil de cuisson (100) selon la revendication 8, où l'ensemble de conduite (190) comprend une plaque supérieure (191) et une plaque inférieure (192) installée sur la plaque supérieure (191) de manière à définir un deuxième canal d'écoulement horizontal (194) entre la plaque supérieure (191) et la plaque inférieure (192).

10. Appareil de cuisson (100) selon la revendication 9, où
le deuxième canal d'écoulement horizontal (194) communique avec la première ouverture (176) dans le premier élément de guidage (170).

11. Appareil de cuisson (100) selon la revendication 9 ou la revendication 10, comprenant en outre :
un deuxième élément de guidage (180) installé sur la plaque supérieure (191) à l'arrière du premier élément de guidage (170),
le deuxième élément de guidage (180) étant prévu pour guider l'air extérieur ayant traversé la première ouverture (176) dans le premier élément de guidage (170) vers le deuxième canal d'écoulement horizontal (194).

12. Appareil de cuisson (100) selon l'une des revendications 9 à 11, où la plaque supérieure (191) est prévue d'une première section inclinée (197) à son extrémité avant,
la première section inclinée (197) étant inclinée vers le bas, et
chacune des sections de blocage latérales (183) étant pourvue d'une deuxième section inclinée (187) correspondant à la première section inclinée (197).

13. Appareil de cuisson (100) selon la revendication 12, où la première section inclinée (197) de la plaque supérieure (191) est pourvue d'au moins une deuxième ouverture (196) de sorte que l'air pénétrant entre le deuxième élément de guidage (180) et la première section inclinée (197) est introduit dans le deuxième canal d'écoulement horizontal (194) par ladite au moins une deuxième ouverture (196).
